# EUROPEAN PATENT APPLICATION

(11) **EP 2 693 485 A1**
(43) Date of publication of application: **05.02.2014**
(21) Application number: 12764148.8
(22) Date of filing: 07.03.2012
(51) Int. Cl.: H01L 29/786, H01B 5/14, H01B 12/06, H01L 21/28

(54) **METHOD FOR MANUFACTURING ORGANIC ELEMENT, METHOD FOR BONDING ORGANIC MOLECULAR CRYSTAL LAYER, METHOD FOR MANUFACTURING FINE LINEAR CONDUCTOR, ORGANIC ELEMENT, AND FINE LINEAR CONDUCTOR**

(30) Priority: 30.03.2011 JP 2011075178
(71) Applicant: Sony Corporation, Tokyo 108-0075 (JP)
(72) Inventor: MURAKAMI, Yosuke, Tokyo 108-0075 (JP); KOBAYASHI, Norihito, Tokyo 108-0075 (JP)
(74) Representative: Jackson, Jonathan Andrew
(86) International application number: PCT/JP2012/001555
(87) International publication number: WO 2012/132250

(57) **Abstract**

[Object] To provide a method of bonding an organic molecular crystal layer, which is capable of bonding an organic molecular crystal layer to an electrode by controlling the alignment of the organic molecular crystal layer, and to provide a method of manufacturing an organic element using the bonding method.

[Solving Means] Alignment of an organic molecular crystal layer 13 with respect to an electrode 12 is controlled by controlling an inclined angle of a side surface 12a of the electrode 12 with respect to a main surface of an insulating base 11, in the case where the electrode 12 and the organic molecular crystal layer 13 are formed on the insulating base 11, the organic molecular crystal layer 13 including an aromatic compound, the organic molecular crystal layer 13 being bonded to the electrode 12. The side surface of the electrode 12 may be formed to have a plurality of surfaces having different inclined angles.

## Description

### Technical Field

The present disclosure relates to a method of manufacturing an organic element, a method of bonding an organic molecular crystal layer, a method of manufacturing a fine linear conductor, an organic element, and a fine linear conductor, and is suitable for use in, for example, various organic elements such as an organic transistor or various fine linear conductors.

### Background Art

An organic molecular crystal is expected to serve as an electronic element such as a thin film transistor (TFT) (see, for example, Non-Patent Document 1), a new superconductor (see, for example, Non-Patent Document 2), or the like. Among various materials, an organic molecular crystal has characteristics that can be formed by vacuum deposition in a low temperature process (see, for example, Non-Patent Document 3), a method without a vacuum process, e.g., applying an organic molecule dissolved in a solvent (see, for example, Non-Patent Document 4), or the like. On the other hand, because the crystalline structure of the organic molecular crystal is affected by the anisotropy of a molecule being a constituent unit, for example, an organic molecular crystal, which has a benzene ring as a skeleton and includes an aromatic compound, has a significant anisotropy. As a result, as seen in pentacene, it often takes a layered structure in a unit of a lamination cycle in a long axial direction of an organic molecule (corresponding to, for example, Lattice Fringes in Non-Patent Document 3). Although the electrogenesis mechanism of the organic molecular crystal having such a layered structure is not completely understood, it is considered that a direction in which pi-orbital overlap is caused among molecules along the layered structure, and a direction perpendicular to the direction have different characteristics. It is considered that in the generation mechanism of superconductivity in the organic molecular crystal, it is important to align the layered structure, from analogy of a copper-oxide superconductor (see, for example, Non-Patent Document 5), to improve the electrical conduction properties. That is, in the case where the organic molecular crystal is used for a device or an electrical lead, it is an important problem to control the crystal orientation. In particular, in the case where an organic molecular crystal including an aromatic compound is formed on a part of a structure that is formed previously, because the size and alignment of the molecule crystal differ depending on the bonding state between the structure and molecules, it is an important problem to control the alignment also in the vicinity of the bonding interface between the electrode and the organic molecular crystal. However, in the prior technique, mainly alignment with respect to the side of a substrate is controlled, e.g., a self-organizing film is formed on the substrate (see, for example, Non-Patent Document 6). Moreover, although, in the interface between the electrode and the organic molecule, improvement in characteristics by the electron transfer such as a thiol treatment (see, for example, Non-Patent Document 7) is reported, there has been no method to microscopically control the alignment at the electrode edge.

Moreover, it is considered that a portion of the electrode and a portion of the insulating film have different conditions of adsorption of the organic molecule, and that many defects occur in the vicinity of the interface, which is a cause of degradation of device characteristics (see, for example, Non-Patent Document 8). As described above, in the prior art, although macroscopic alignment control with respect to the substrate is achieved, microscopic alignment is not controlled in the fine bonding interface with the electrode, in the current situation. Moreover, a practical superconductor mainly includes borides, copper oxides, or metals. Because the technique for processing the superconductor or technique for combining the superconductor with a stabilizing material (see, for example, Patent Document 9) undergoes the high-temperature process or mechanical high deformation process, it has been difficult to combine the superconductor with a molecular element or bio-element.

As for the fine wire using an organic molecule, although a method of manufacturing a fullerene fine wire (see, for example, Patent Document 1) has been known, the method has had a limitation in that two types of solvents are needed and a fullerene is precipitated at the boundary between the solvents.

### Citation List

### Patent Document

Patent Document 1: Japanese Patent No. 4035618
Patent Document 2: Japanese Patent Application Laid-open No. 2010-6794

### Non-Patent Document

Non-Patent Document 1: N.Yoneya et al.,SID 06 DIGEST,p.123 (2006)
Non-Patent Document 2: R.Mitsuhashi et al.,Nature,Vol.464,76(2010)
Non-Patent Document 3: Y.Murakami et al.,Phys.Rev.Lett.103,146102(2009)
Non-Patent Document 4: T.Ohe et al.,Appl.Phys.Lett.93,053303(2008)
Non-Patent Document 5: M.Machida et al.,Phys.Rev.Lett.75,3178(1995)
Non-Patent Document 6: Y.-Y.Lin et al.,IEEE ELECTRON DEVICE LETTERS,VOL.18,NO.12(1997)
Non-Patent Document 7: D.J.Gundlach et al.,IEEE ELECTRON DEVICE LETTERS,VOL.22,NO.12(2001)
Non-Patent Document 8: C.D.Dimitrakopoulos et al.,Adv.Mater.2002,14,No.2,January 16
Non-Patent Document 9: Takeuchi et al., Materials Science Outlook 2006, "5.Superconducting Material (5) Practical Superconducting Wire," p. 310 N. Kobayashi, M. Sasaki and K. Nomoto: Chem. Mater. 21(2009)552

### Disclosure of the Invention

### Problem to be solved by the Invention

In view of the above, a problem to be solved by the present disclosure is to provide a method of manufacturing an organic element having favorable characteristics, which is capable of bonding an organic molecular crystal layer to an electrode by controlling the alignment of the organic molecular crystal layer, and to provide an organic element that can be manufactured by using the manufacturing method.

Another problem to be solved by the present disclosure is to provide a method of bonding an organic molecular crystal layer, which is capable of bonding an organic molecular crystal layer to an electrode by controlling the alignment of the organic molecular crystal layer.

Still another problem to be solved by the present disclosure is to provide a method of manufacturing a fine linear conductor having favorable characteristics, which is capable of bonding a fine linear organic molecular crystal layer to a fine linear electrode by controlling the alignment of the organic molecular crystal layer, and to provide a fine linear conductor that can be manufactured by using the manufacturing method.

### Means for solving the Problem

In order to solve the above-mentioned problem, the present inventors have conducted intensive studies. They have accidentally found that in the process of the study, when an electrode is formed on an insulator, an organic molecular crystal layer including an aromatic compound is formed thereafter, and the organic molecular crystal layer is bonded to the electrode, if an inclined angle of a side surface of the electrode with respect to a surface of the insulator is changed, the alignment of the organic molecular crystal layer with respect to the electrode is changed. Then, based on the findings thus obtained uniquely, they have conducted intensive researches, leading to the present disclosure.

That is, in order to solve the above-mentioned problem, the present disclosure is a method of manufacturing an organic element including controlling alignment of an organic molecular crystal layer with respect to an electrode by controlling an inclined angle of a side surface of the electrode with respect to a main surface of an insulating base, in the case where the electrode and the organic molecular crystal layer are formed on the insulating base, the organic molecular crystal layer including an aromatic compound, the organic molecular crystal layer being bonded to the electrode.

Assuming that the inclined angle of the side surface of the above-mentioned electrode is θ, the relationship 0°<θ<90° is established. The entire side surface of the electrode may be flat, or the entire or a part of the side surface may be curved (concave surface, convex surface, or surface having a concave surface portion and a convex surface portion). In the case where the entire or a part of the side surface of the electrode is curved, an average inclined angle of the curved surface is used for θ. The side surface of the electrode may be formed to have a plurality of surfaces having different inclined angles. For example, the side surface of the electrode may be formed to have an upper surface and a lower surface, and the inclined angle of the lower surface may be smaller than that of the upper surface.

The insulating base typically has a flat main surface, and the electrode and the organic molecular crystal layer bonded to the electrode are formed on the main surface. However, a groove may be formed on the main surface of the insulating base, and the electrode and the organic molecular crystal layer may be formed in the groove.

As the insulating base, a fiber-like insulator may be used as necessary. In this case, for example, the electrode and the organic molecular crystal layer are formed so as to have a fine linear shape, on an outer peripheral surface of the fiber-like insulator in a central axial direction of the fiber-like insulator or a direction inclined with respect to the central axial direction.

The organic element may be basically any one as long as an organic molecular crystal layer including an aromatic compound is bonded to an electrode in the organic element. Examples of the organic element include an organic transistor and an organic photoelectric conversion element. In the organic transistor, the organic molecular crystal layer is a semiconductor layer in which a channel is formed, and the electrode to which the organic molecular crystal layer is bonded is a source electrode or a drain electrode. In the organic photoelectric conversion element, the organic molecular crystal layer is an organic photoelectric conversion layer, and the electrode to which the organic molecular crystal layer is bonded is an electrode for drawing current from the organic photoelectric conversion layer, which is provided at one end and the other end thereof. At least a part of the organic molecular crystal layer may be a superconductor. In this case, it is possible to manufacture an organic superconductor element.

The aromatic compound included in the organic molecular crystal layer is classified into a benzenoid aromatic compound, a heteroaromatic compound, and a non-benzenoid benzenoid aromatic compound. Examples of the benzenoid aromatic compound include a condensed ring aromatic compound such as a benzo condensed ring compound. Examples of the heteroaromatic compound include furan, thiophene, pyrrole, and imidazole. Examples of the non-benzenoid benzenoid aromatic compound include annulen, azulene, cyclopentadienyl anion, cycloheptatrienyl cation (tropylium ion), tropone, metallocene, and acepleiadylene.

Among the above-mentioned aromatic compounds, favorably, the condensed-ring compound is used. Examples of the condensed-ring compound include, but not limited to, acenes (naphthalene, anthracene, tetracene, pentacene, etc.), phenanthrene, chrysene, triphenylene, tetraphene, pyrene, picene, pentaphene, perylene, helicene, and coronene. As the aromatic compound, favorably, also a dioxaanthanthrene compound such as 6,12-dioxaanthanthrene (so-called perixanthenoxanthene, 6,12-dioxaanthanthrene, which is abbreviated as "PXX" in some cases) is used (see Non-Patent Document 10 and Patent Document 2).

Moreover, the present disclosure is a method of bonding an organic molecular crystal layer including controlling alignment of an organic molecular crystal layer with respect to an electrode by controlling an inclined angle of a side surface of the electrode with respect to a main surface of an insulating base, in the case where the organic molecular crystal layer is bonded to the electrode, the organic molecular crystal layer including an aromatic compound, the electrode being formed on the insulating base.

The description of the above-mentioned method of manufacturing an organic element is applicable to the method of bonding an organic molecular crystal layer unless contrary to the nature thereof.

Moreover, the present disclosure is a method of manufacturing a fine linear conductor, including controlling alignment of a fine linear organic molecular crystal layer with respect to a fine linear electrode by controlling an inclined angle of a side surface of the electrode with respect to a main surface of an insulating base, in the case where the electrode and the organic molecular crystal layer are formed on the insulating base, the organic molecular crystal layer including an aromatic compound, the organic molecular crystal layer being bonded to the electrode.

The description of the above-mentioned method of manufacturing an organic element is applicable to the method of manufacturing a fine linear conductor unless contrary to the nature thereof.

Moreover, the present disclosure is an organic element, including an electrode formed on an insulating base, a side surface of the electrode including a plurality of surfaces having different inclined angles with respect to a main surface of the insulating base, and an organic molecular crystal layer including an aromatic compound, the organic molecular crystal layer being bonded to the electrode, alignment of the organic molecular crystal layer with respect to the electrode being different from each other on the plurality of surfaces.

The description of the above-mentioned method of manufacturing an organic element is applicable to the organic element unless contrary to the nature thereof.

Moreover, the present disclosure is a fine linear conductor, including a fine linear electrode formed on an insulating base, a side surface of the electrode including a plurality of surfaces having different inclined angles with respect to a main surface of the insulating base, and a fine linear organic molecular crystal layer including an aromatic compound, the organic molecular crystal layer being bonded to the electrode, alignment of the organic molecular crystal layer with respect to the electrode being different from each other on the plurality of surfaces.

In the present disclosure described above, because it is possible to control the alignment of organic molecular crystal layer with respect to the electrode while substantially maintaining the layered structure of the organic molecular crystal layer, the organic molecular crystal layer can be formed in the optimal alignment with respect to the electrode while utilizing the original characteristics of the organic molecular crystal layer. Alternatively, it is possible to form a plurality of parts having different alignment on the organic molecular crystal layer.

### Effect of the Invention

According to the present disclosure, it is possible to bond an organic molecular crystal layer to an electrode by controlling the alignment of the organic molecular crystal layer, and to obtain an organic element having favorable characteristics.

Moreover, according to the present disclosure, it is possible to bond a fine linear organic molecular crystal layer to a fine linear electrode by controlling the alignment of the organic molecular crystal layer, and to obtain a fine linear conductor having favorable characteristics.

### Brief Description of Drawings

[Fig. 1] A cross-sectional view for explaining a method of bonding an organic molecular crystal layer according to a first embodiment.
[Fig. 2] A cross-sectional view for explaining the method of bonding an organic molecular crystal layer according to the first embodiment.
[Fig. 3] A plan view showing an example of the pattern shape and arrangement of an electrode and an organic molecular crystal layer to which the method of bonding an organic molecular crystal layer according to the first embodiment is applicable.
[Fig. 4] A cross-sectional view for explaining a method of bonding an organic molecular crystal layer according to a second embodiment.
[Fig. 5] A cross-sectional view showing a method of preparing a sample in Example.
[Fig. 6] A drawing-substituting photograph showing a cross-sectional transmission electron micrograph of the sample in Example.
[Fig. 7] A drawing-substituting photograph showing a cross-sectional transmission electron micrograph of the sample in Example.
[Fig. 8] A cross-sectional view for explaining a method of bonding an organic molecular crystal layer according to a third embodiment.
[Fig. 9] A cross-sectional view for explaining a method of bonding an organic molecular crystal layer according to a fourth embodiment.
[Fig. 10] A cross-sectional view showing a top-gate organic transistor according to a fifth embodiment.
[Fig. 11] A cross-sectional view showing a bottom-gate organic transistor according to a sixth embodiment.
[Fig. 12] A cross-sectional view for explaining a method of bonding an organic molecular crystal layer according to a seventh embodiment.
[Fig. 13] A cross-sectional view for explaining a method of bonding an organic molecular crystal layer according to an eighth embodiment.
[Fig. 14] A cross-sectional view for explaining a method of bonding an organic molecular crystal layer according to a ninth embodiment.

### Mode(s) for Carrying Out the Invention

Hereinafter, a mode for carrying out the invention (hereinafter referred to as "embodiment") will be described. It should be noted that description will be given in the following order.
1. First Embodiment (method of bonding organic molecular crystal layer)
2. Second Embodiment (method of bonding organic molecular crystal layer)
3. Third Embodiment (method of bonding organic molecular crystal layer)
4. Fourth Embodiment (method of bonding organic molecular crystal layer)
5. Fifth Embodiment (top-gate organic transistor and method of manufacturing the same)
6. Sixth Embodiment (bottom-gate organic transistor and method of manufacturing the same)
7. Seventh Embodiment (fine linear conductor and method of manufacturing the same)
8. Eighth Embodiment (fine linear conductor and method of manufacturing the same)
9. Ninth Embodiment (fine linear conductor and method of manufacturing the same)

### <1. First Embodiment>

### [Method of Bonding Organic Molecular Crystal Layer]

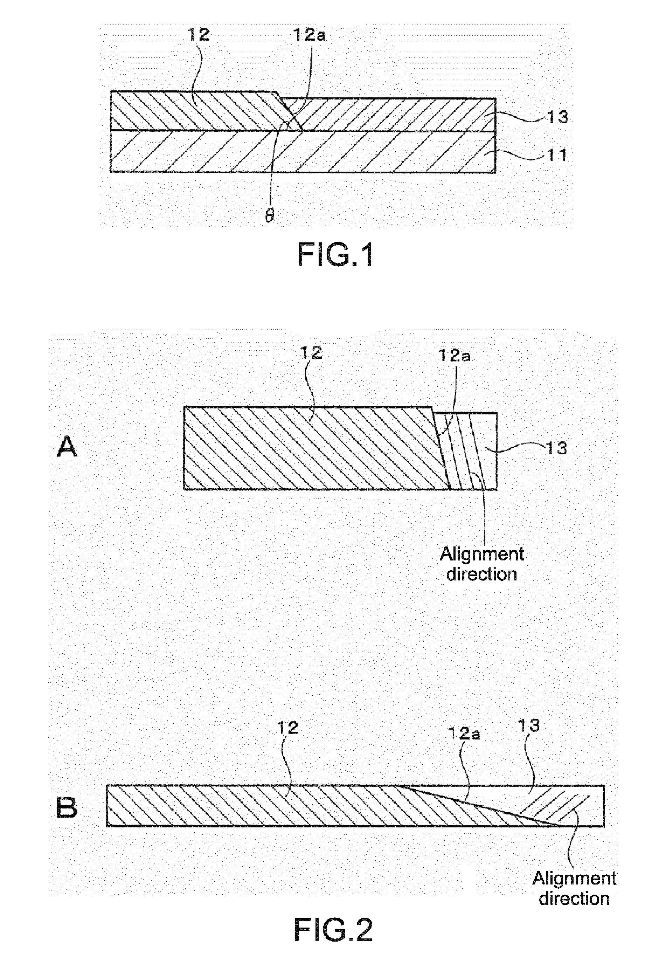

Fig. 1 shows a method of bonding an organic molecular crystal layer according to a first embodiment. The organic molecular crystal layer includes an aromatic compound.

As shown in Fig. 1, in the method of bonding an organic molecular crystal layer according to the first embodiment, an electrode 12 is formed on an insulating base 11 having a flat main surface, for example. As the insulating base 11, those previously known can be used and are selected as necessary. For example, a silicon substrate or glass substrate whose surface includes an insulating film such as a silicon dioxide (SiO₂) film can be used. As the material of the electrode 12, those previously known can be used and are selected as necessary. For example, gold (Au), chromium (Cr), tungsten (W), aluminum (Al), aluminum alloys, platinum (Pt), copper (Cu), and copper alloys can be used. As a method of forming the electrode 12, those previously known can be used and are selected as necessary. For example, a vacuum deposition method using a predetermined mask (shadow mask, etc.), or the like can be used. An inclined angle θ of a side surface 12a of the electrode 12 with respect to the main surface of the insulating base 11 satisfies the relationship 0°<θ<90°. The side surface 12a of the electrode 12 may be flat, or may be a concave surface, a convex surface, or a surface having a concave surface portion and a convex surface portion. In the latter case, an average inclined angle of the entire side surface 12a is used for θ.

Next, on the insulating base 11 on which the electrode 12 is formed, an organic molecular crystal layer 13 including an aromatic compound is formed so as to bond to the side surface 12a of the electrode 12. As the aromatic compound included in the organic molecular crystal layer 13, those described above can be used and are selected as necessary. As a method of forming the organic molecular crystal layer 13, for example, a vacuum deposition method, a coating method, and an immersion method can be used and are selected as necessary. By forming the organic molecular crystal layer 13 so as to have a fine linear shape, it is possible to form a fine linear conductor.

In this case, by controlling the inclined angle θ of the side surface 12a of the electrode 12, it is possible to control the alignment of the organic molecular crystal layer 13 with respect to the electrode 12. For example, as shown in Fig. 2A, if the side surface 12a of the electrode 12 is formed to be relatively steep, specifically, if the inclined angle θ is set to, for example, 60° or more and 80° or less, it is possible to align the organic molecular crystal layer 13 in parallel with the side surface 12a of the electrode 12. Moreover, as shown in Fig. 2B, if the inclined angle θ of the side surface 12a of the electrode 12 is set to, for example, 5° or more and 20° or less, it is possible to align the organic molecular crystal layer 13 in a direction inclined with respect to the side surface 12a of the electrode 12. In any case of those shown in Fig. 2A and Fig. 2B, it is possible to align a portion of the organic molecular crystal layer 13, which is formed on the insulating base 11, in parallel with the main surface of the insulating base 11.

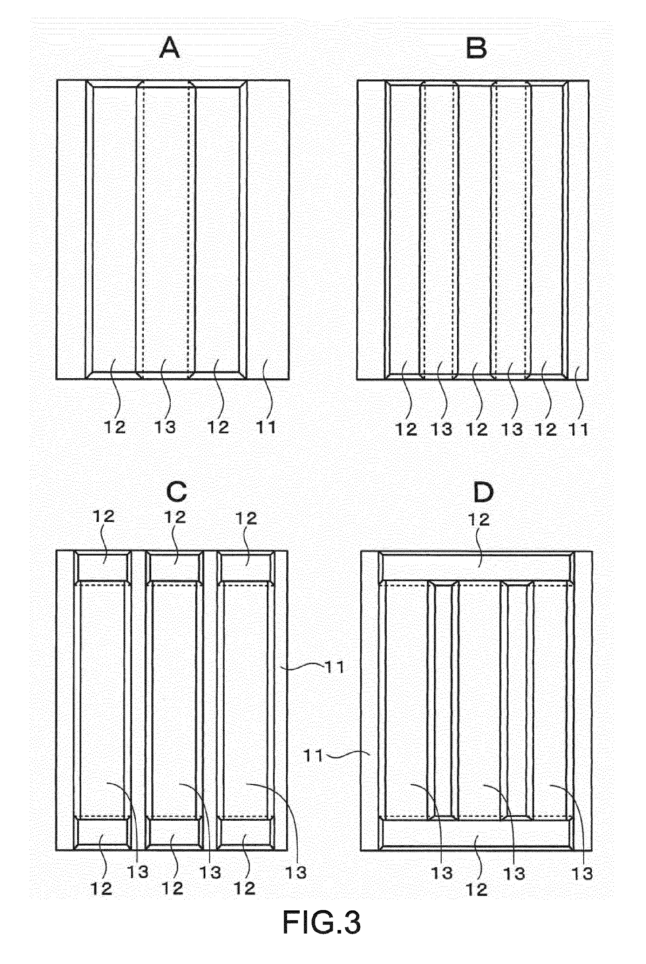

The pattern shape and arrangement of the electrode 12 and organic molecular crystal layer 13 formed on the insulating base 11 are selected as necessary. In A to D of Fig. 3, examples of the pattern shape and arrangement of the electrode 12 and organic molecular crystal layer 13 are shown.

According to the first embodiment, by controlling the inclined angle θ of the side surface 12a of the electrode 12, it is possible to control the alignment of the organic molecular crystal layer 13 in a portion bonded to the electrode 12 while substantially maintaining the layered structure of the organic molecular crystal layer 13. Therefore, it is possible to bond the organic molecular crystal layer 13 to the electrode 12 in the optimal alignment, to attempt to improve the characteristics of a grain boundary of the organic molecular crystal layer 13 in a portion bonded to the electrode 12, and to obtain favorable bonding characteristics, while utilizing the original characteristics of the organic molecular crystal layer 13. In particular, it is possible to smoothly move a carrier between the electrode 12 and the organic molecular crystal layer 13, and to attempt to reduce the transmission loss. Moreover, because the electrode 12 and organic molecular crystal layer 13 can be formed by a low temperature process or an ambient temperature process, by using a superconductor disclosed in Non-Patent Document 2 as the organic molecular crystal layer 13, it is possible to form a superconductor by a low temperature process or an ambient temperature process, which has been difficult previously, and to achieve an organic superconducting element. Furthermore, because the electrode 12 and organic molecular crystal layer 13 can be formed by a low temperature process or an ambient temperature process, by, for example, combining a molecular element or bio-element with a part of the electrode 12, it is possible to couple the superconductor with the molecular element or bio-element, or to integrate these elements.

### <2. Second Embodiment>

### [Method of Bonding Organic Molecular Crystal Layer]

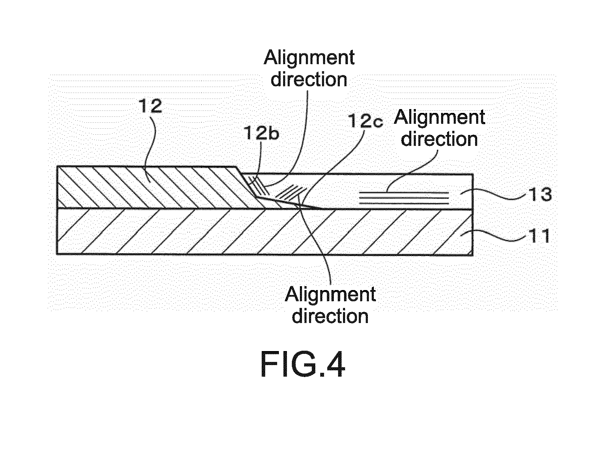

As shown in Fig. 4, in a method of bonding an organic molecular crystal layer according to a second embodiment, the electrode 12 is formed on the insulating base 11 having a flat main surface, for example. In this case, the side surface of the electrode 12 is formed so as to have an upper side surface 12b and a lower side surface 12c continued thereto. The inclined angle θ of the upper side surface 12b is set to, for example, 60° or more and 80° or less, similarly to Fig. 2A. The inclined angle θ of the lower side surface 12c is set to, for example, 5° or more and 20° or less, similarly to Fig. 2B.

Next, on the insulating base 11 on which the electrode 12 is formed, the organic molecular crystal layer 13 is formed so as to bond to the upper side surface 12b and the lower side surface 12c of the electrode 12, similarly to the first embodiment. In this case, it is possible to align a portion of the organic molecular crystal layer 13, which is bonded to the upper side surface 12b, in parallel with the upper side surface 12b. Moreover, it is possible to align a portion of the organic molecular crystal layer 13, which is bonded to the lower side surface 12c, in a direction inclined with respect to the lower side surface 12c.

### <Example>

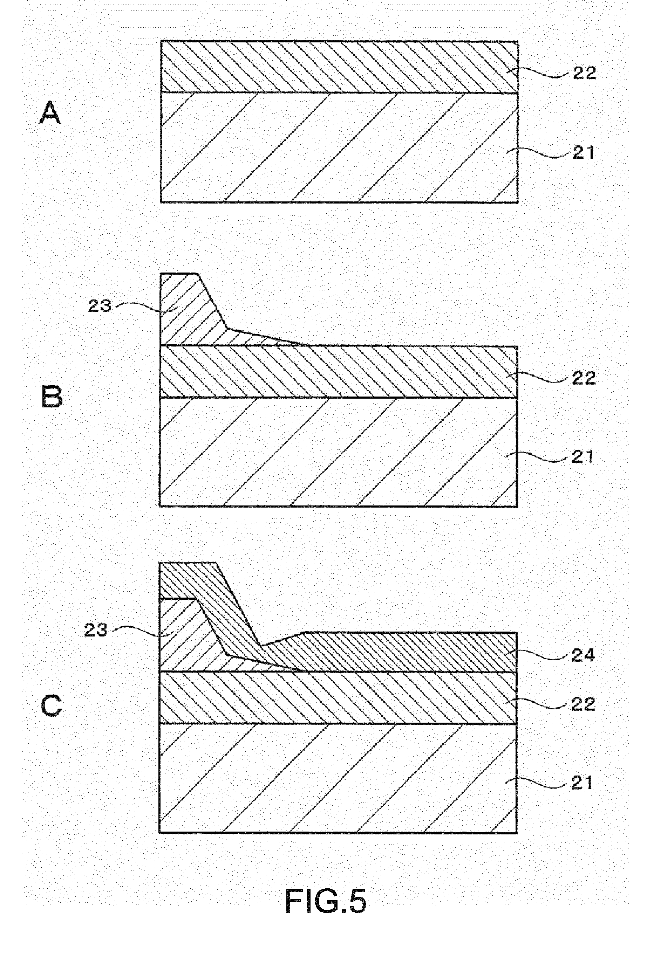

As shown in Fig. 5A, an SiO₂ film 22 having a thickness of about 150 nm was formed on an Si substrate 21 by a thermal oxidation method, and was used as the insulating base 11

Next, as shown in Fig. 5B, Au was deposited on the SiO₂ film 22 by a vacuum deposition method using a shadow mask (metal mask), and thus an Au electrode 23 having an upper side surface and a lower side surface was formed.

Next, as shown in Fig. 5C, a pentacene film 24 having a thickness of about 40 nm was formed as the organic molecular crystal layer 13 by a vacuum deposition method while controlling the film thickness using a crystal oscillator, and was bonded to an upper side surface, a lower side surface, and an upper surface of the Au electrode 23. Subsequently, in order to attempt to improve the bonding characteristics between the Au electrode 23 and the pentacene film 24, annealing was performed for about 2 hours at the temperature of about 100°C in a vacuum chamber that was used for vacuum deposition.

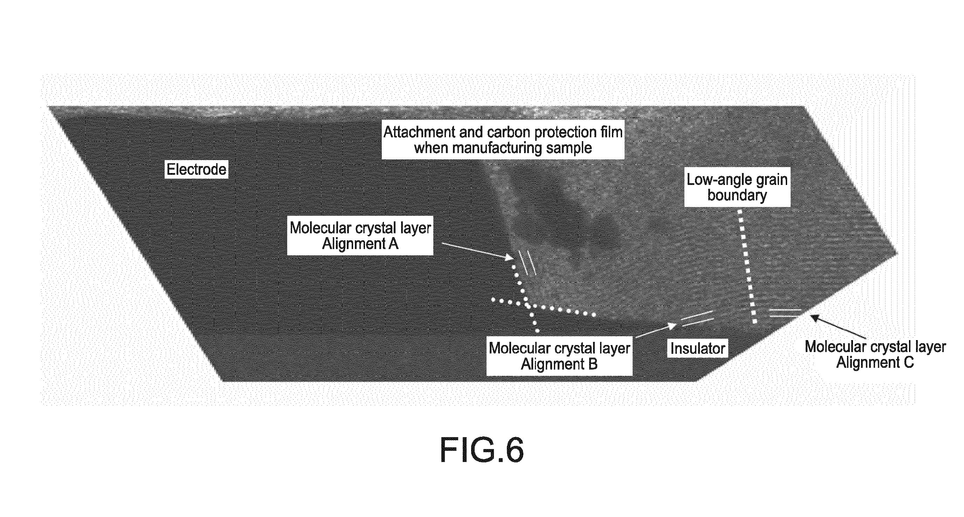

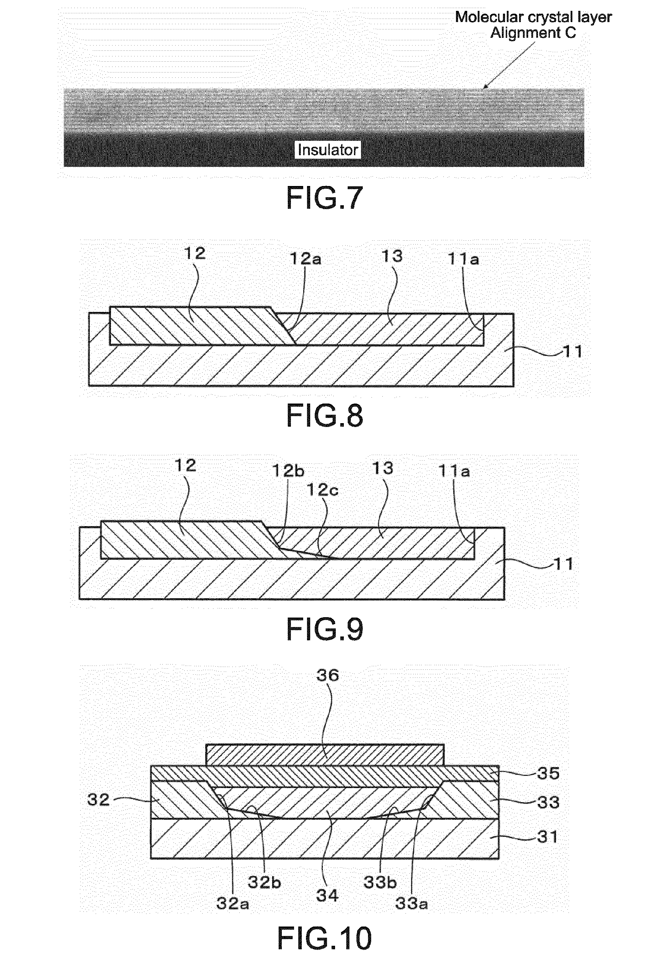

A cross-sectional transmission electron micrograph of a sample in which the pentacene film 24is formed in such a way is shown in Fig. 6. As is obvious from Fig. 6, on the SiO₂ film 22 being an insulator, the Au electrode 23 having an upper side surface inclined by about 70 to 75° with respect to the surface of the SiO₂ film 22 and a lower surface inclined by about 10° with respect to the surface of the SiO₂ film 22 is formed. A portion of the pentacene film 24, which is bonded to the upper side surface of the Au electrode 23 is aligned in a direction in parallel with the upper side surface (alignment A). A portion of the pentacene film 24, which is bonded to the lower side surface of the Au electrode 23, is aligned in a direction substantially perpendicular to the upper side surface (alignment B). A portion of the pentacene film 24, which is directly formed on the SiO₂ film 22 on the outside of the Au electrode 23, is aligned in a direction in parallel with the surface of the SiO₂ film 22 (alignment C). The portion of the alignment B of the pentacene film 24 is gradually matched with the portion of the alignment C, and a low-angle grain boundary is formed at the boundary between the portion of the alignment B and the portion of the alignment C. The portion of the alignment C of the pentacene film 24 is enlarged to be shown in Fig. 7.

As described above, according to the second embodiment, the electrode 12 having the upper side surface 12b and the lower side surface 12c that have different inclined angles with respect to the main surface of the insulating base 11 is formed, and the organic molecular crystal layer 13 is formed so as to bond to the electrode 12. Therefore, it is possible to align a portion of the organic molecular crystal layer 13, which is bonded to the upper side surface 12b of the electrode 12, in parallel with the upper side surface 12b while substantially maintaining the layered structure of the organic molecular crystal layer 13, and to align a portion of the organic molecular crystal layer 13, which is bonded to the lower side surface 12c, in a direction inclined with the lower side surface 12c. Therefore, for example, it is possible to obtain favorable bonding characteristics at the bonding portion between the electrode 12 and the organic molecular crystal layer 13 while utilizing the original characteristics of the organic molecular crystal layer 13. The bonding structure is suitable for use in various organic elements, e.g., a transistor.

### <3. Third Embodiment>

### [Method of Bonding Organic Molecular Crystal Layer]

As shown in Fig. 8, in a method of bonding an organic molecular crystal layer according to a third embodiment, after a groove 11a is formed on the main surface of the insulating base 11, the electrode 12 is formed in the groove 11a and the organic molecular crystal layer 13 is formed so as to bond to the side surface 12a of the electrode 12.

In the third embodiment, other than the above are the same as those in the first embodiment.

According to the third embodiment, it is possible to obtain the same advantage as that of the first embodiment.

### <4. Fourth Embodiment>

### [Method of Bonding Organic Molecular Crystal Layer]

As shown in Fig. 9, in a method of bonding an organic molecular crystal layer according to a fourth embodiment, after the groove 11a is formed on the main surface of the insulating base 11, the electrode 12 having the upper side surface 12b and the lower side surface 12c is formed in the groove 11a and the organic molecular crystal layer 13 is formed so as to bond to the upper side surface 12b and the lower side surface 12c of the electrode 12.

In the fourth embodiment, other than the above are the same as those in the second embodiment.

According to the fourth embodiment, it is possible to obtain the same advantage as that of the first embodiment.

### <5. Fifth Embodiment>

### [Organic Transistor]

Fig. 10 shows an organic transistor according to a fifth embodiment. The organic transistor is a top-gate organic transistor.

As shown in Fig. 10, in the organic transistor, a source electrode 32 and a drain electrode 33 are provided on an insulating base 31 having a flat main surface, for example, and an organic molecular crystal layer 34 is provided on a portion of the insulating base 31 between the source electrode 32 and the drain electrode 33. As the material of the source electrode 32 and the drain electrode 33, the same material as that of the electrode 12 can be used. The source electrode 32 has an upper side surface 32a and a lower side surface 32b, and the drain electrode 33 has an upper side surface 33a and a lower side surface 33b. One end of the organic molecular crystal layer 34 is bonded to the upper side surface 32a and the lower side surface 32b of the source electrode 32, and the other end of the organic molecular crystal layer 34 is bonded to the upper side surface 33a and the lower side surface 33b of the drain electrode 33. Similarly to the first embodiment, portions of the organic molecular crystal layer 34, which are bonded to the upper side surface 32a of the source electrode 32 and the upper side surface 33a of the drain electrode 33, are aligned in directions in parallel with the upper side surface 32a and the upper side surface 33a, respectively. Moreover, portions of the organic molecular crystal layer 34, which are bonded to the lower side surface 32b of the source electrode 32 and the lower side surface 33b of the drain electrode 33, are aligned in directions inclined with the lower side surface 32b and the lower side surface 33b, respectively. Moreover, a portion of the organic molecular crystal layer 34 on the insulating base 31 is aligned in parallel with the main surface of the insulating base 31.

On the organic molecular crystal layer 34, the source electrode 32, and the drain electrode 33, a gate insulating film 35 is formed. The gate insulating film 35 can be formed by for example, an insulating polymer. Examples of the polymer include polystyrene, polycarbonate, polydimethylsiloxane, nylon, polyimide, cyclic olefin copolymer, epoxy polymer, cellulose, polyoxymethylene, polyolefin polymer, polyvinyl polymer, polyester polymer, polyether polymer, polyamide polymer, fluorinated polymer, biodegradable plastic, phenol resin, amino resin, unsaturated polyester resin, diallyl phthalate resin, epoxy resin, polyimide resin, polyurethane resin, silicone resin, and copolymer obtained by combining various polymer units. Specific examples of the polymer include poly(α-methylstyrene) and cycloolefin copolymer. As the gate insulating film 35, an inorganic insulating film such as an SiO₂ film may be used, as necessary. The thickness of the gate insulating film 35 is selected as necessary.

On the gate insulating film 35, a gate electrode 36 is provided. As the material of the gate electrode 36, various ones previously known can be used, and are selected as necessary.

### [Method of Manufacturing Organic Transistor]

As shown in Fig. 10, the source electrode 32 and the drain electrode 33 are formed on the insulating base 31, similarly to the first embodiment.

Next, the organic molecular crystal layer 34 is formed, similarly to the first embodiment.

Next, an insulator is formed on the organic molecular crystal layer 34, the source electrode 32, and the drain electrode 33, by a vacuum deposition method, a coating method, an immersion method, or the like. Thus, the gate insulating film 35 is formed.

Next, after a film including a conductive material is formed on the gate insulating film 35 by a vacuum deposition method or the like, the film is patterned by an etching process. Thus, the gate electrode 36 is formed.

In this way, an intended top-gate organic transistor is manufactured.

According to the fifth embodiment, by controlling the inclined angles of the upper side surface 32a and lower side surface 32b of the source electrode 32, and the upper side surface 33a and lower side surface 33b of the drain electrode 33, it is possible to control the alignment of the organic molecular crystal layer 34 with respect to the source electrode 32 and the drain electrode 33. Therefore, it is possible to bond the organic molecular crystal layer 34 to the source electrode 32 and the drain electrode 33 in the optimal alignment, and to obtain favorable bonding characteristics. As a result, it is possible to cause the organic molecular crystal layer 34 to sufficiently show the original properties, and to obtain a top-gate organic transistor having favorable properties.

### <6. Sixth Embodiment>

### [Organic Transistor]

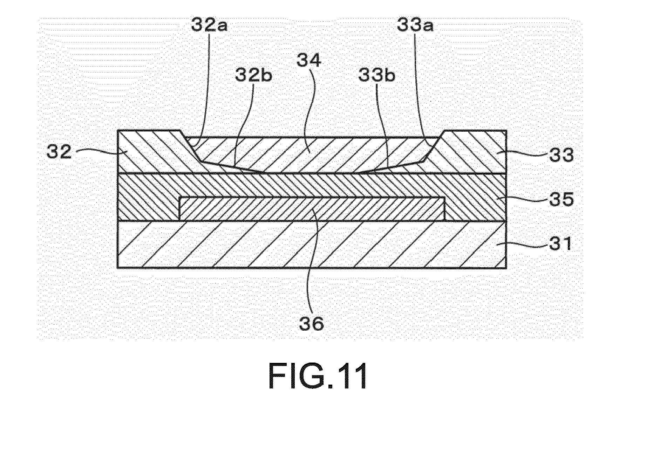

Fig. 11 shows an organic transistor according to a sixth embodiment. The organic transistor is a bottom-gate organic transistor.

As shown in Fig. 11, in the organic transistor, the gate electrode 36 is provided on the insulating base 31 having a flat main surface, for example, and the gate insulating film 35 is provided so as to cover the gate electrode 36. The source electrode 32 and the drain electrode 33 are provided on the gate insulating film 35, and the organic molecular crystal layer 34 is provided on a portion of the gate insulating film 35 between the source electrode 32 and the drain electrode 33.

The configuration of the organic transistor other than the above is the same as that of the organic transistor according to the fifth embodiment.

### [Method of Manufacturing Organic Transistor]

As shown in Fig. 11, after the gate electrode 36 is formed on the insulating base 31, the gate insulating film 35 is formed so as to cover the gate electrode 36, similarly to the fifth embodiment.

Next, the source electrode 32 and the drain electrode 33 are formed on the gate insulating film 35, similarly to the first embodiment.

Next, the organic molecular crystal layer 34 is formed, similarly to the first embodiment.

In this way, an intended bottom-gate organic transistor is manufactured.

According to the sixth embodiment, by the bottom-gate organic transistor, it is possible to obtain the same advantage as that of the fifth embodiment.

### <7. Seventh Embodiment>

### [Fine Linear Conductor]

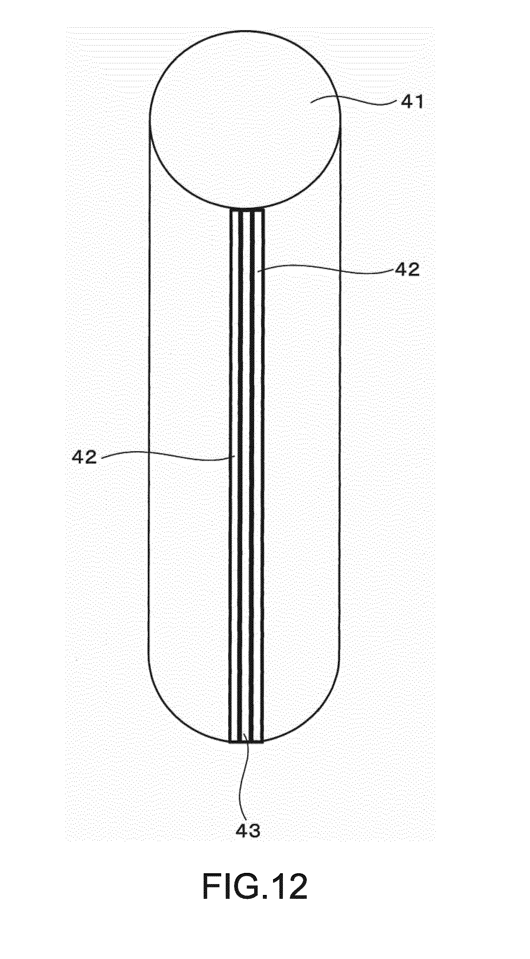

Fig. 12 shows a fine linear conductor according to a seventh embodiment.

As shown in Fig. 12, in the fine linear conductor, on an outer peripheral surface of a fiber-like insulator 41 having a columnar shape, a pair of linear electrodes 42 extending in a central axial direction of the fiber-like insulator 41 is provided, and a linear organic molecular crystal layer 43 is provided so as to bond to the pair of linear electrodes 42.

### [Method of Manufacturing Fine Linear Conductor]

As shown in Fig. 12, on the outer peripheral surface of the fiber-like insulator 41, the pair of linear electrodes 42 extending in the central axial direction of the fiber-like insulator 41 is formed, similarly to the first embodiment. Next, the linear organic molecular crystal layer 43 is formed so as to bond to the pair of linear electrodes 42, similarly to the first embodiment.

In the seventh embodiment, other than the above are the same as those in the first embodiment.

According to the seventh embodiment, it is possible to obtain the same advantage as that of the first embodiment in the case where the fiber-like insulator 41 is used as the insulating base. Moreover, it is possible to smoothly move a carrier between linear electrodes 42 and the linear organic molecular crystal layer 43 being an electrical lead, and to attempt to reduce the transmission loss. Furthermore, by using, for example, the superconductor disclosed in Non-Patent Document 2 as the linear organic molecular crystal layer 43, it is possible to achieve an organic superconducting element. According to the organic superconducting element, it is possible to attempt to improve the characteristics such as critical current of the organic molecular crystal layer 43 including a superconductor.

### <8.Eighth Embodiment>

### [Fine Linear Conductor]

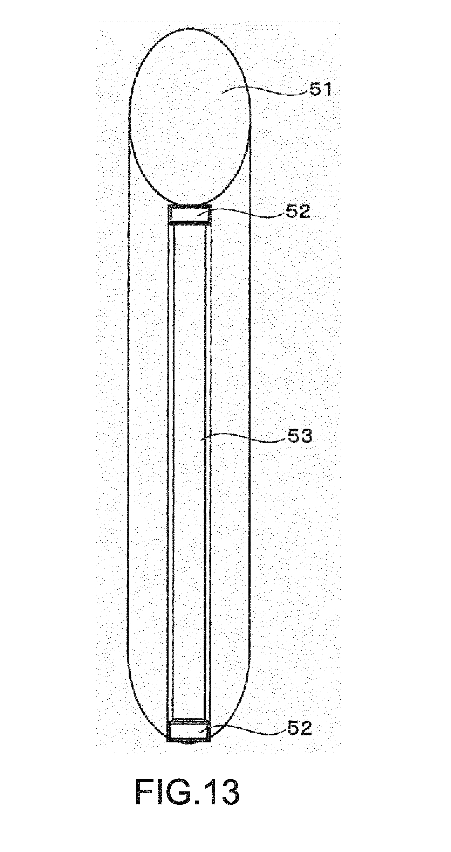

Fig. 13 shows a fine linear conductor according to an eighth embodiment.

As shown in Fig. 13, in the fine linear conductor, a pair of electrodes 52 is provided on an outer peripheral surface of a fiber-like insulator 51 having a columnar shape at one end and the other end in a central axial direction of the fiber-like insulator 51, and a linear organic molecular crystal layer 53 extending in the central direction of the fiber-like insulator 51 is provided so as to bond to the pair of electrodes 52.

### [Method of Manufacturing Fine Linear Conductor]

As shown in Fig. 13, the pair of electrodes 52 is formed on the outer peripheral surface of the fiber-like insulator 51 at one end and the other end in the central axial direction of the fiber-like insulator 51, and the linear organic molecular crystal layer 53 extending in the central direction of the fiber-like insulator 51 is formed so as to bond to the pair of electrodes 52, similarly to the first embodiment.

In the eighth embodiment, other than the above are the same as those in the first embodiment.

According to the eighth embodiment, it is possible to obtain the same advantage as that of the seventh embodiment.

### <9. Ninth Embodiment>

### [Fine Linear Conductor]

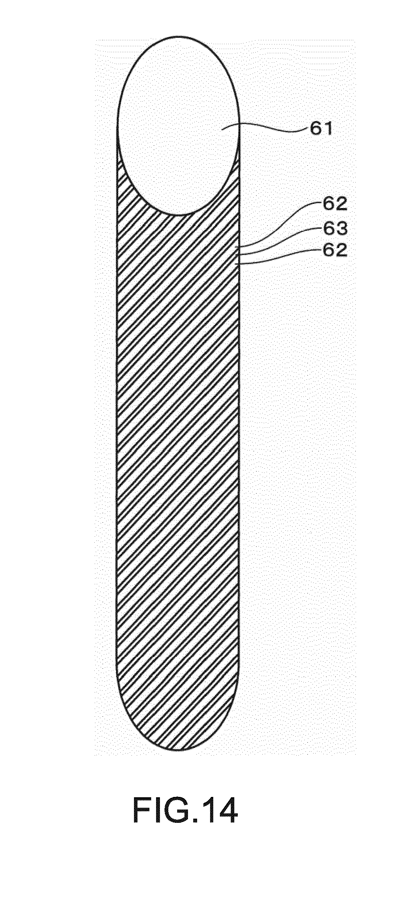

Fig. 14 shows a fine linear conductor according to a ninth embodiment.

As shown in Fig. 14, in the fine linear conductor, a linear electrode 62 is provided on an outer peripheral surface of a fiber-like insulator 61 having a columnar shape so as to have a double helix shape and to surround the fiber-like insulator 61. A linear organic molecular crystal layer 63 is provided so as to have a double helix shape similarly and to bond to the linear electrode 62.

### [Method of Manufacturing Fine Linear Conductor]

As shown in Fig. 14, the linear electrode 62 is formed on the outer peripheral surface of the fiber-like insulator 61 having a columnar shape so as to surround the fiber-like insulator 61, and the linear organic molecular crystal layer 63 is formed so as to bond to the linear electrode 62.

In the ninth embodiment, other than the above are the same as those in the first embodiment.

According to the ninth embodiment, it is possible to obtain the same advantage as that of the seventh embodiment.

Although embodiments and Example have been specifically described, the present technology is not limited to the embodiments and Example, and various modifications can be made.

For example, the numerical value, structure, process, shape, material, and the like in the embodiments and Example are only examples, and different numerical value, structure, process, shape, material, and the like may be used as necessary. Description of Reference Symbols

- 11: insulating base
- 11a: groove
- 12: electrode
- 12a: side surface
- 12b: upper side surface
- 12c: lower side surface
- 13: organic molecular crystal layer
- 31: insulating base
- 32: source electrode
- 33: drain electrode
- 34: organic molecular crystal layer
- 35: gate insulating film
- 36: gate electrode
- 41: fiber-like insulator
- 42: linear electrode
- 43: organic molecular crystal layer
- 51: fiber-like insulator
- 52: electrode
- 53: organic molecular crystal layer
- 61: fiber-like insulator
- 62: linear electrode
- 63: organic molecular crystal layer

## Claims

1. A method of manufacturing an organic element, comprising
controlling alignment of an organic molecular crystal layer with respect to an electrode by controlling an inclined angle of a side surface of the electrode with respect to a main surface of an insulating base, in a case where the electrode and the organic molecular crystal layer are formed on the insulating base, the organic molecular crystal layer including an aromatic compound, the organic molecular crystal layer being bonded to the electrode.

2. The method of manufacturing an organic element according to claim 1, wherein
the inclined angle θ of the side surface of the electrode satisfies the relationship 0°<θ<90°.

3. The method of manufacturing an organic element according to claim 2, wherein
the side surface of the electrode is formed to have a plurality of surfaces having different inclined angles.

4. The method of manufacturing an organic element according to claim 3, wherein
the side surface of the electrode is formed to have an upper surface and a lower surface, and
the inclined angle of the lower surface is smaller than that of the upper surface.

5. The method of manufacturing an organic element according to claim 1, wherein
the aromatic compound is a condensed-ring compound.

6. The method of manufacturing an organic element according to claim 5, wherein
the condensed-ring compound is acenes.

7. The method of manufacturing an organic element according to claim 1, wherein
the insulating base has a flat main surface.

8. The method of manufacturing an organic element according to claim 1, wherein
the insulating base is a fiber-like insulator, and
the electrode and the organic molecular crystal layer are formed so as to have a fine linear shape, on an outer peripheral surface of the fiber-like insulator in a central axial direction of the fiber-like insulator or a direction inclined with respect to the central axial direction.

9. The method of manufacturing an organic element according to claim 1, wherein
a groove is formed on the main surface of the insulating base, and
the electrode and the organic molecular crystal layer are formed in the groove.

10. The method of manufacturing an organic element according to claim 1, wherein
the organic element is an organic transistor, and the electrode is a source electrode or a drain electrode.

11. The method of manufacturing an organic element according to claim 1, wherein
at least a part of the organic molecular crystal layer is a superconductor.

12. A method of bonding an organic molecular crystal layer, comprising
controlling alignment of an organic molecular crystal layer with respect to an electrode by controlling an inclined angle of a side surface of the electrode with respect to a main surface of an insulating base, in a case where the organic molecular crystal layer is bonded to the electrode, the organic molecular crystal layer including an aromatic compound, the electrode being formed on the insulating base.

13. A method of manufacturing a fine linear conductor, comprising
controlling alignment of a fine linear organic molecular crystal layer with respect to a fine linear electrode by controlling an inclined angle of a side surface of the electrode with respect to a main surface of an insulating base, in a case where the electrode and the organic molecular crystal layer are formed on the insulating base, the organic molecular crystal layer including an aromatic compound, the organic molecular crystal layer being bonded to the electrode.

14. An organic element, comprising:
an electrode formed on an insulating base, a side surface of the electrode including a plurality of surfaces having different inclined angles with respect to a main surface of the insulating base; and
an organic molecular crystal layer including an aromatic compound, the organic molecular crystal layer being bonded to the electrode, alignment of the organic molecular crystal layer with respect to the electrode being different from each other on the plurality of surfaces.

15. A fine linear conductor, comprising:
a fine linear electrode formed on an insulating base, a side surface of the electrode including a plurality of surfaces having different inclined angles with respect to a main surface of the insulating base; and
a fine linear organic molecular crystal layer including an aromatic compound, the organic molecular crystal layer being bonded to the electrode, alignment of the organic molecular crystal layer with respect to the electrode being different from each other on the plurality of surfaces.
